# EUROPEAN PATENT APPLICATION

(11) **EP 4 579 255 A1**
(43) Date of publication of application: **02.07.2025**
(21) Application number: 23872987.5
(22) Date of filing: 22.09.2023
(51) Int. Cl.: G01R 31/367, G01R 31/396, G06F 11/30, G06F 16/901, B60L 58/12

(54) **BATTERY DATA PROCESSING APPARATUS AND OPERATION METHOD THEREOF**

(30) Priority: 26.09.2022 KR 20220121945
(71) Applicant: LG Energy Solution, Ltd., Seoul 07335 (KR)
(72) Inventor: KIM, Hyo Jung, Daejeon 34122 (KR); CHO, Kyu Chul, Daejeon 34122 (KR); SEO, Seung Yeop, Daejeon 34122 (KR)
(74) Representative: Goddar, Heinz J.
(86) International application number: PCT/KR2023/014567
(87) International publication number: WO 2024/071870

(57) **Abstract**

A data processing apparatus according to an embodiment of the present disclosure includes a first controller configured to select a first raw data group from a raw data storage, store a first copy data group corresponding to the first raw data group in a buffer storage, and delete the first raw data group of the raw data storage when the first copy data group is stored in the buffer storage, a first loader configured to receive the first copy data group from the buffer storage, store a first storage data group corresponding to the first copy data group in a database, and delete the first copy data group of the buffer storage when the first storage data group is stored in the database, and a monitoring unit configured to determine whether the first copy data group is processed, by monitoring the buffer storage.

## Description

### [TECHNICAL FIELD]

### CROSS-REFERENCE TO RELATED APPLICATION

This application claims priority to and the benefit of Korean Patent Application No. 10-2022-0121945 filed in the Korean Intellectual Property Office on September 26, 2022, the entire content of which is incorporated herein by reference.

### TECHNICAL FIELD

Embodiments disclosed herein relate to an apparatus for processing battery data and an operating method of the apparatus.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries mounted on electric vehicles tend to deteriorate as they are repeatedly charged and discharged. For example, as batteries mounted on electric vehicles are repeatedly charged and discharged for driving thereof, their capacity and resistance may deteriorate and their remaining life may decrease. In addition, the degree of deterioration and remaining life of the battery may change depending on use conditions of the electric vehicles.

When the remaining life of the battery rapidly decreases, safety issues may occur in the use of the electric vehicles. Accordingly, there is a need for a method of diagnosing a battery state by rapidly processing data of a battery mounted on an electric vehicle.

### [DISCLOSURE]

### [TECHNICAL PROBLEM]

Embodiments disclosed herein aim to provide an apparatus for processing raw data and an operating method of the apparatus.

Embodiments disclosed herein aim to provide an apparatus and an operating method thereof, in which copy data corresponding to raw data stored in a raw data storage is stored in a buffer storage and storage data corresponding to the copy data is stored in a database.

Technical problems of the embodiments disclosed herein are not limited to the above-described technical problems, and other unmentioned technical problems would be clearly understood by one of ordinary skill in the art from the following description.

### [TECHNICAL SOLUTION]

A data processing apparatus according to an embodiment of the present disclosure includes a first controller configured to select a first raw data group from a raw data storage, store a first copy data group corresponding to the first raw data group in a buffer storage, and delete the first raw data group of the raw data storage when the first copy data group is stored in the buffer storage, a first loader configured to receive the first copy data group from the buffer storage, store a first storage data group corresponding to the first copy data group in a database, and delete the first copy data group of the buffer storage when the first storage data group is stored in the database, and a monitoring unit configured to determine whether the first copy data group is processed by monitoring the buffer storage.

According to an embodiment, when the first loader fails to store the first storage data group corresponding to the first copy data group in the database, the monitoring unit may be further configured to receive the first copy data group from the buffer storage, store the first storage data group corresponding to the first copy data group in the database and delete the first copy data group of the buffer storage when the first storage data group is stored in the database.

According to an embodiment, the data processing apparatus may further include a second controller configured to select a second raw data group from the raw data storage, store a second copy data group corresponding to the selected second raw data group in the buffer storage, and delete the second raw data group of the raw data storage when the second copy data group is stored in the buffer storage.

According to an embodiment, the data processing apparatus may further include a timing controller configured to execute the second controller when the first controller deletes the first raw data group of the raw data storage.

According to an embodiment, the data processing apparatus may further include a second loader configured to receive the second copy data group from the buffer storage, store a second storage data group corresponding to the second copy data group in the database, and delete the second copy data group of the buffer storage when the second storage data group is stored in the database.

According to an embodiment, the data processing apparatus may further include a timing controller configured to execute the second controller when the first controller fails to select the first raw data group.

According to an embodiment, the second raw data group selected by the second controller may include raw data that the first controller fails to select.

According to an embodiment, the first controller may be further configured to match the first copy data group with first time information and store them, the first time information being information about a generation time of the first copy data group.

According to an embodiment, the monitoring unit may be further configured to compare the first time information with reference time information to determine whether the first copy data group is processed.

An operating method of a data processing apparatus according to another embodiment of the present disclosure includes selecting a first raw data group from a raw data storage, storing a first copy data group corresponding to the first raw data group in a buffer storage, deleting the first raw data group of the raw data storage when the first copy data group is stored in the buffer storage, storing a first storage data group corresponding to the first copy data group in a database, and deleting the first copy data group of the buffer storage when the first copy data group is stored in the database.

According to another embodiment, the operating method of the data processing apparatus may further include determining, by a monitoring unit, whether the first copy data group is processed, by monitoring the buffer storage.

According to another embodiment, the operating method of the data processing apparatus may further include matching the first copy data group with first time information and store them, the first time information being information about a generation time of the first copy data group.

According to another embodiment, the determining of whether the first copy data group is processed may include comparing, by the monitoring unit, the first time information with reference time information to determine whether the first copy data group is processed.

According to another embodiment, the operating method of the data processing apparatus may further include, when the first loader fails to store the first storage data group corresponding to the first copy data group in the database, determining, by the monitoring unit, that processing of the first copy data group is omitted, receiving, by the monitoring unit, the first copy data group from the buffer storage, storing, by the monitoring unit, the first storage data group corresponding to the first copy data group in the database, and deleting the first copy data group of the buffer storage.

According to another embodiment, the operating method of the data processing apparatus may further include executing, by a timing controller, a second controller when a first controller deletes the first raw data group of the raw data storage, selecting, by the second controller, a second raw data group from the raw data storage, storing, by the second controller, a second copy data group corresponding to the selected second raw data group in the buffer storage, deleting, by the second controller, the second raw data group of the raw data storage, receiving, by a second loader, the second copy data group from the buffer storage, storing, by the second loader, a second storage data group corresponding to the second copy data group in the database, and deleting, by the second loader, the second copy data group of the buffer storage.

According to another embodiment, the operating method of the data processing apparatus may further include executing, by a timing controller, a second controller, when a first controller fails to select the first raw data group and selecting, by the second controller, a second raw data group including raw data the first controller fails to select, from the raw data storage.

### [ADVANTAGEOUS EFFECTS]

The data processing apparatus according to an embodiment disclosed herein may control an execution timing of a controller that processes raw data through a timing controller, thereby preventing redundant processing of raw data.

The data processing apparatus according to an embodiment disclosed herein may prevent redundant processing of raw data by processing the raw data with a next executed controller, in case of a failure in raw data selection.

The data processing apparatus according to an embodiment disclosed herein may determine whether copy data is processed, by monitoring a buffer storage through a monitoring unit, and prevent omission of copy data processing.

Moreover, various effects recognized directly or indirectly from the disclosure may be provided.

### [DESCRIPTION OF DRAWINGS]

FIG. 1 is a block diagram showing a configuration of a general battery pack.
FIG. 2 is a block diagram of a data processing apparatus according to an embodiment disclosed herein.
FIG. 3 is a view for describing an operating method of a battery management apparatus, according to an embodiment disclosed herein.
FIG. 4 is a block diagram of a hardware configuration of a computing system for performing a data processing apparatus and an operating method thereof, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

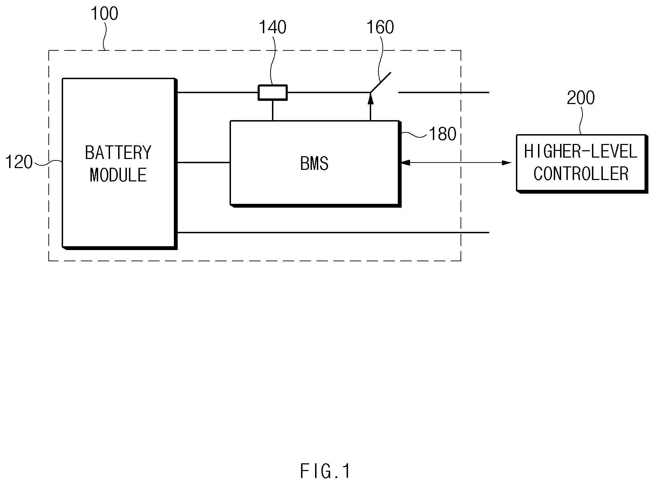

FIG. 1 is a block diagram showing a configuration of a general battery pack.

Referring to FIG. 1, a battery control system including a battery pack 100 and a higher-level controller 200 included in a higher-level system according to an embodiment of the present disclosure is schematically shown.

As shown in FIG. 1, the battery pack 100 may include a battery module 120 that includes one or more battery cells and is chargeable/dischargeable, a switching unit 160 serially connected to a positive (+) terminal side or a negative (-) terminal side of the battery module 120 to control a charging/discharging current flow of the battery module 120, and a battery management system (e.g., RBMS) 180 for control and management to prevent over-charge, over-discharge, etc., of the battery pack 100 and for monitoring data regarding the battery module 120. The battery pack 100 may include the battery module 120, the sensor 140, the switching unit 160, and the battery management system (BMS) 180 provided in plural.

The sensor 140 may be connected between the battery module 120 and the battery management system 180 to sense a voltage, a current, a temperature, an internal resistance, an impedance, etc., of the battery module 120 and transmit the same to the battery management system 180.

As the switching unit 160 which is an element for controlling a current flow for charging or discharging of the battery module 120, for example, at least one relay, magnetic contactor, etc., may be used according to specifications of the battery pack 100.

The battery management system 180, which is an interface for receiving measurement values of the above-described various parameters, may include a plurality of terminals and a circuit, etc., connected thereto to process input values. The battery management system 180 may control on/off of the switching unit 160, e.g., a relay, a contactor, etc., and may be connected to the battery module 120 to monitor the state of each battery module 120.

The higher-level controller 200 may transmit a control signal regarding the battery pack 100 through the battery management system 180. The battery management system 180 may be controlled in terms of an operation thereof based on a signal applied from the higher-level controller 200.

According to an embodiment, the battery pack 100 and the higher-level controller 200 may be provided in a vehicle, and the battery management system 180 may receive data such as a voltage, a current, a temperature, an internal resistance, an impedance, the number of times of charge and discharge, etc., of the battery modules 120 from the sensor 140.

The data such as the voltage, current, temperature, internal resistance, impedance, the number of times of charge and discharge, etc., of the battery module 120 may be data that is a basis for determining state information of the battery pack 100 included in the vehicle. Thus, the data such as the voltage, current, temperature, internal resistance, impedance, the number of times of charge and discharge, etc., of the battery modules 120 may be referred to as battery data.

The battery management system 180 may transmit the battery data to the higher-level controller 200 that may transmit the battery data to a raw data storage provided separately. That is, the battery data may be raw data processed in the data processing apparatus.

According to an embodiment, the battery pack 100 may include the plurality of battery modules 120, and in this case, a plurality of pieces of raw data may be output from one battery pack 100.

The battery pack 100 may be mounted on a vehicle actually in operation to perform charging and discharging cycles or experimentally perform charging and discharging cycles under an experimental driving conditions similar to the actual driving conditions of the vehicle.

For example, the battery module 120 may be mounted on a vehicle and output data such as voltage, current, temperature, internal resistance, impedance, the number of times of charge and discharge, etc., when actually driven, and when experimental charging and discharging cycles are performed under the experimental driving conditions, data such as voltage, current, temperature, internal resistance, impedance, the number of times of charge and discharge, etc., may be output as raw data from the battery module 120.

According to an embodiment, the raw data output from the battery module 120 mounted on the vehicle when the battery module 120 is actually driven may be affected by driving habits of a driver, an environment where the vehicle is actually driven, actual charging and discharging periods of the battery, etc.

Driving conditions preset for generating an experimental lifetime index may include, for example, acceleration driving conditions, fast charging conditions, city driving conditions, long-distance driving conditions of the vehicle, etc. Preset driving conditions may reflect an environment where the vehicle is driven, a type of the vehicle, a charging/discharging period, etc.

In other words, the preset driving conditions may mean exemplary driving scenario conditions including behaviors of the vehicle and an operating environment of the vehicle.

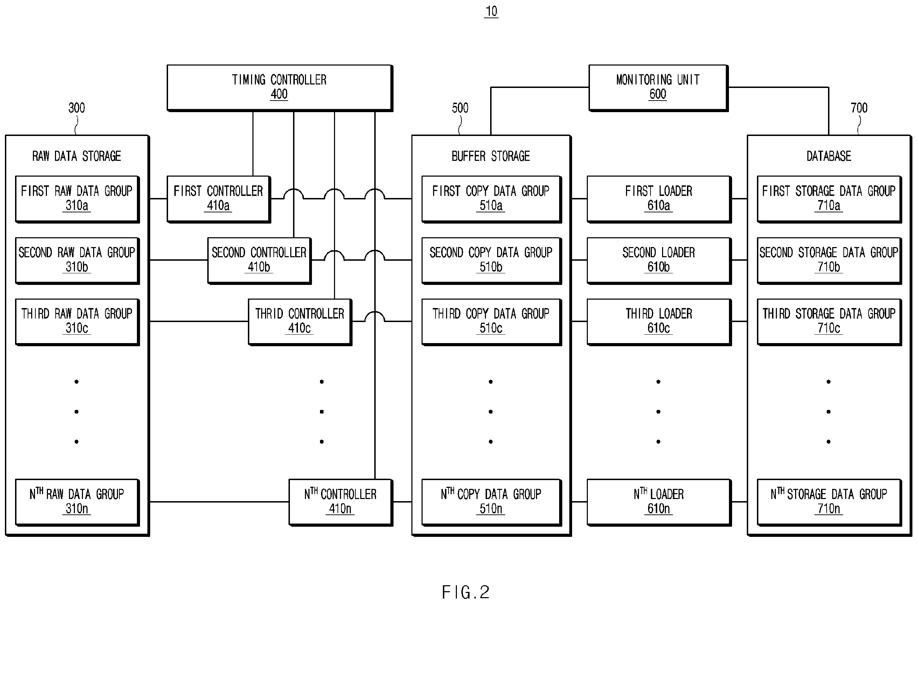

FIG. 2 is a block diagram of a data processing apparatus according to an embodiment disclosed herein.

A data processing apparatus 10 may include a raw data storage 300 configured to receive raw data, a scheduler 400 configured to determine execution timings of a plurality of controllers 410a, 410b, 410c to 410n, the plurality of controllers 410a, 410b, 410c to 410n, select raw data groups 310a, 310b, 310c to 310n from the raw data storage 300 and store a copy data group (e.g., 510a) corresponding to a selected raw data group (e.g., 310a) in a buffer storage 500, the buffer storage 500 configured to temporarily store copy data groups 510a, 510b, 510c to 510n, a monitoring unit 600 configured to monitor the buffer storage 500 to determine whether the copy data group (e.g., 510a) is processed, a plurality of loaders 610a, 610b, 610c to 610n configured to receive the copy data group (e.g., 510a) and store a storage data group (e.g., 710a) corresponding to the copy data group 510a in a database 700, and the database 700 configured to store raw data in the form of storage data.

The raw data storage 300 may be a device for receiving raw data that is a processing target. The raw data storage 300 may collect and keep raw data and receive the raw data from an external device or an external server.

According to an embodiment, a device for transmitting the raw data to the raw data storage 300 may be referred to as a data source, that may input the raw data to the raw data storage 300 in real time. The raw data storage 300 may include volatile or nonvolatile memory.

The raw data input to the raw data storage 300 may be classified into the plurality of raw data groups 310a, 310b, 310c to 310n.

For example, raw data included in the first raw data group 310a may be selected by the first controller 410a, and first storage data 710a corresponding to the raw data included in the first raw data group 310a may be stored in the database 700 after undergoing a series of processing operations.

The raw data groups 310a, 310b, 310c to 310n may include different sizes of raw data.

That is, the controllers 410a, 410b, 410c to 410n may classify the raw data included in the raw data storage 300 into the plurality of raw data groups 310a, 310b, 310c to 310n.

The timing controller 400 may determine a processing timing for a raw data group (e.g., 310a) by controlling execution timings of the controllers 410a, 410b, 410c to 410n.

The timing controller 400 may control the execution timings of the controllers 410a, 410b, 410c to 410n such that the controllers 410a, 410b, 410c to 410n are sequentially executed. The timing controller 400 may transmit a trigger signal for executing the controllers 410a, 410b, 410c to 410n, and according to an embodiment, the trigger signal may include information about raw data groups to be selected by the controllers 410a, 410b, 410c to 410n.

For example, the timing controller 400 may control a timing such that the second controller 410b may operate when the first controller 410a deletes the first raw data group 310a to be processed from the raw data storage 300 after selecting the first raw data group 310a from the raw data storage 300 and storing the first copy data group 510a corresponding to the selected first raw data group 310a in the buffer storage 500.

The timing controller 400 may control raw data to be processed in a distributed manner for each raw data group by controlling the controllers 410a, 410b, 410c to 410n to be sequentially executed.

The timing controller 400 may store information about raw data selection of the controllers 410a, 410b, 410c to 410n and transmit information about raw data that has not been processed by a controller due to an error to other controllers.

The operating timings of the controllers 410a, 410b, 410c to 410n may be determined according to a computing power of the data processing apparatus 10.

For a higher computing power of the data processing apparatus 10, an interval between the operating timings of the controllers 410a, 410b, 410c to 410n may be shorter. That is, as the computing power of the data processing apparatus 10 increases, the real-time property of the data processing apparatus 10 may increase.

Given a constant computing power, as the data size of the raw data groups 310a, 310b, 310c to 310n processed by the controllers 410a, 410b, 410c to 410n decreases, the real-time property of the data processing apparatus 10 may increase.

The data processing apparatus 10 may include a preset number of controllers 410a, 410b, 410c to 410n, each of which (e.g., 410a) may select a raw data group (e.g., 310a) from the raw data storage 300 and store a copy data group (e.g., 510a) corresponding to the selected raw data group 310a in the buffer storage 500, and then delete the selected raw data group 310a from the raw data storage 300.

As the controller (e.g., 410a) deletes, from the raw data storage 300, the raw data group 310a of which the copy data group (e.g., 510a) corresponding thereto is stored in the buffer storage 500, previously processed raw data may not be selected when another controller (e.g., 410b) selects the raw data group (e.g., 3 10b). Thus, redundant processing of raw data may be prevented.

According to an embodiment, when an error occurs, for example, when the controller (e.g., 410a) fails to select a raw data group or a copy data group corresponding to the raw data group fails to be stored, etc., the corresponding raw data group may not be deleted. In this case, the timing controller 400 may execute another controller (e.g., 410b). The timing controller 400 may transmit information about raw data not processed by the controller 410a having an error occurred to the other controller 410b to allow the controller 410b to select a raw data group including the raw data not processed by the controller 410a.

The buffer storage 500 may be a storage space that temporarily stores the copy data groups 510a, 510b, 510c to 510n. According to an embodiment, the buffer storage 500 may be a storage device including a volatile or nonvolatile memory.

The buffer storage 500 may be a physical storage that stores raw data in the form of temporary copy data when moving the raw data from the raw data storage 300 to the database 700.

The copy data groups 510a, 510b, 510c to 510n stored in the buffer storage 500 may respectively correspond to the raw data groups 310a, 310b, 310c to 310n.

The controllers 410a, 410b, 410c to 410n may respectively match the copy data groups 510a, 510b, 510c to 510n with information about generation times of the copy data groups 510a, 510b, 510c to 510n and store them in the buffer storage 500.

The information about the generation times of the copy data groups 510a, 510b, 510c to 510n may have a millisecond unit, and according to an embodiment, the information about the generation times may be stored in a separate storage space in the buffer storage 500.

For example, information about a generation time of the first copy data group 510a may be referred to as first time information, and information about a generation time of the n^{th} copy data group 510n may be referred to nth time information (n is an integer of 1 or greater).

The monitoring unit 600 may monitor the buffer storage 500 and determine whether each of the copy data groups 510a, 510b, 510c to 510n is processed.

The copy data groups 510a, 510b, 510c to 510n may be processed by loaders 610a, 610b, 610c to 610n. The monitoring unit 600 may monitor the buffer storage 500 at preset time intervals, and identify time information of the copy data groups 510a, 510b, 510c to 510n stored in the buffer storage 500.

The monitoring unit 600 may compare the time information of the copy data groups 510a, 510b, 510c to 510n with reference time information. The reference time information may include information about a time for the monitoring unit 600 to determine whether the copy data groups 510a, 510b, 510c to 510n are processed.

When the time information of the copy data groups 510a, 510b, 510c to 510n is different from the reference time information by a preset threshold time or greater, the monitoring unit 600 may determine that processing of a copy data group having time information being different from the reference time information by a threshold time or greater is omitted. According to an embodiment, the threshold time may be set based on a time required in average to process the copy data groups 510a, 510b, 510c to 510n.

For example, when the first loader 610a fails to store the first storage data group 710a corresponding to the first copy data group 510a in the database 700, processing of the first copy data group 510a may be omitted.

As the omitted first copy data group 510a is left in the buffer storage 500, the monitoring unit 600 may compare the reference time information including information about the current time with first time information of the first copy data group 510a and determine that the first time information is different from the reference time information by the threshold time or greater.

The monitoring unit 600 may receive the processing-omitted first copy data group 510a from the buffer storage 500 and store the first storage data group 710a corresponding to the received first copy data group 510a in the database 700. When the corresponding first storage data group 710a is stored in the database 700, the monitoring unit 600 may delete the first copy data group 510a of the buffer storage 500.

The loaders 610a, 610b, 610c to 610n may respectively receive the copy data groups 510a, 510b, 510c to 510n stored in the buffer storage 500, store storage data groups 710a, 710b, 710c to 710n corresponding to the received copy data groups in the database 700, and delete the copy data groups 510a, 510b, 510c to 510n stored in the buffer storage 500.

The loaders 610a, 610b, 610c to 610n may consecutively operate after the controllers 410a, 410b, 410c to 410n are executed. For example, the first loader 610a may operate successively from execution of the first controller 410a, and as the first controller 410a and the first loader 610a operate consecutively, the first raw data group 310a of the raw data storage 300 may be stored as the first storage data group 710a in the database 700 through a series of operations.

As the loaders 610a, 610b, 610c to 610n operate successively from the above-described controllers 410a, 410b, 410c to 410n, a copy data group processed by each of the loaders 610a, 610b, 610c to 610n may be determined in advance.

For example, the copy data group to be processed by the first loader 610a may be the first copy data group 510a that is stored in the buffer storage 500 by the first controller 410.

According to an embodiment, when the controller fails to select a raw data group or a copy data group corresponding to the raw data group fails to be stored, a loader corresponding to the failing controller may not operate.

The database 700 may mean a set of storage data managed integrally, and the stored data may be structured and managed.

The database 700 may store the plurality of storage data groups 710a, 710b, 710c to 710n that may correspond to raw data processed in real time in a distributed manner from the raw data storage 300.

The data processing apparatus 10 may process and analyze raw data input in real time to the raw data storage 300 and store a result of the analysis, thereby efficiently using the raw data.

The data processing apparatus 10 disclosed in the present disclosure may process in real time raw data input through the timing controller 400, the controllers 410a, 410b, 410c to 410n, the monitoring unit 600, and the loaders 610a, 610b, 610c to 610n and process the entire data without data omission.

Moreover, the data processing apparatus 10 disclosed in the present disclosure may enable the same raw data to be processed at a time, thereby preventing redundant processing and improving the efficiency of raw data processing.

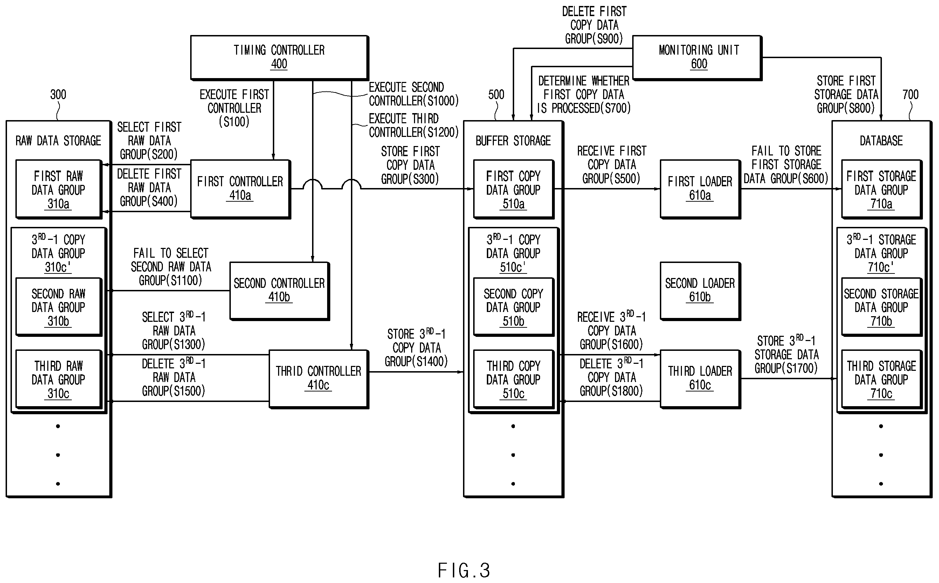

FIG. 3 is a view for describing an operating method of a battery management apparatus, according to an embodiment disclosed herein.

For convenience of description, content overlapping with a matter previously described in FIG. 2 will be omitted. Moreover, for convenience of description, some components included in the data processing apparatus 10 will be omitted.

The timing controller 400 may execute the first controller 410a to process raw data stored in the raw data storage 300, in operation S100. The timing controller 400 may transmit a trigger signal for executing the first controller 410a. According to an embodiment, the trigger signal may include information about a raw data group to be selected by the first controller 410a.

The first controller 410a may select the first raw data group 310a from the raw data storage 300, in operation S200. The first controller 410a may select raw data stored in the raw data storage 300 as the first raw data group 310a.

The first controller 410a may store the first copy data group 510a corresponding to the selected first raw data group 310a in the buffer storage 500, in operation S300. The first controller 410a may generate first time information that is information about a generation time of the first copy data group 510a, match the first copy data group 510a with the first time information, and store them in the buffer storage 500.

The first controller 410a may store the first copy data group 510a and then delete the first raw data group 310a of the raw data storage 300, in operation S400.

As the first controller 410a deletes the first raw data group 310a after storing the first copy data group 510a, redundant processing of the raw data by the plurality of controllers may be prevented.

The first loader 610a may receive the first copy data group 510a from the buffer storage 500, in operation S500.

In a normal operation, the first loader 610a may store the first storage data group 710a corresponding to the first copy data group 510a in the database 700. However, due to an operation error of the first loader 610a, the first loader 610a may fail to store the first storage data group 710a in the database 700, in operation S600.

The monitoring unit 600 may monitor the buffer storage 500 at preset time intervals and determine whether the first copy data group 510a is processed in the buffer storage 500, in operation S700.

When the first loader 610a fails to store the first storage data group 710a, the first copy data group 510a may not be deleted from the buffer storage 500.

The first copy data group 510a may be matched with the first time information and stored, and the monitoring unit 600 may compare the first time information with the reference time information to determine whether the first copy data group 510a is processed. According to an embodiment, the monitoring unit 600 may determine that processing of the first copy data group 510a is omitted, when the first time information and the reference time information are different from each other by a threshold time or greater.

When determining that processing of the first copy data group 510a is omitted, the monitoring unit 600 may receive the first copy data group 510a from the buffer storage 500 and store the first storage data group 710a corresponding to the first copy data group 510a in the database 700, in operation S800.

Thereafter, the monitoring unit 600 may delete the first copy data group 510a from the buffer storage 500, in operation S900.

As the monitoring unit 600 is included, the data processing apparatus 10 may store a storage data group without omission even when the loaders (e.g., 610a) do not operate normally.

The first controller 410a and the first loader 610a may operate consecutively.

When the first controller 410a deletes the first raw data group 310a in operation S400, the timing controller 400 may execute the second controller 410b in operation S1000.

The timing controller 400 may transmit the trigger signal to the second controller 410b, and the trigger signal may include information about a raw data group to be selected by the second controller 410b.

The timing controller 400 may control a timing such that the controllers 410a, 410b, and 410c sequentially operate, thereby preventing a raw data group, which is a processing target, from being redundant and controlling raw data to be processed in a distributed manner in real time.

When the second controller 410b operates normally, the second controller 410b may select the second raw data group 310b as a processing target. However, when an error occurs in the second controller 410b and thus the second controller 410b fails to select the second raw data group 310b as a processing target in operation S1100, the timing controller 400 may execute the third controller 410c in operation S1200. The timing controller 400 may execute the third controller 310c based on the trigger signal.

According to another embodiment, when the second controller 410b selects the second raw data group 310b as a processing target, but fails to select the second copy data group 510b corresponding to the second raw data group 310b in the buffer storage 500, the timing controller 400 may execute the third controller 410c.

The timing controller 400 may determine whether an error occurs in the second controller 410b, based on whether the second raw data group 310b is deleted. That is, when the second raw data group 310b is not deleted, the timing controller 400 may determine that an error occurs in the second controller 410b and execute the third controller 410c.

The timing controller 400 may determine whether an error occurs in the second controller 410b, and transmit to the third controller 410c through a trigger signal, information about the raw data group 310b that the second controller 410b fails to process.

The second loader 610b may continuously operate after execution of the second controller 410b, such that when the second controller 410b fails to select the second raw data group, the second loader 610b may not operate.

The third controller 410c may select a 3^{rd}-1 raw data group 310c' from the raw data storage 300, in operation S1300.

According to an embodiment, the 3^{rd}-1 raw data group 310c' selected by the third controller 410c may include raw data (raw data included in the second raw data group 310b) that the second controller 410b fails to select. The 3rd-1 raw data group 310c' may include the third raw data group 310c that may originally select by the third controller 410c.

As the third controller 410c selects the 3^{rd}-1 raw data group 310c', omission of raw data processing may be prevented.

The third controller 410c may store the 3^{rd}-1 copy data group 510c' corresponding to the 3^{rd}-1 raw data group 310c' in the buffer storage 500, in operation S1400.

The third controller 410c may store the 3^{rd}-1 copy data group 510c' in the buffer storage 500 and then delete the 3^{rd}-1 raw data group 310c' of the raw data storage 300, in operation S1500.

The third loader 610c may receive the 3^{rd}-1 copy data group 510c' in operation S1600.

The third loader 610c may store the 3^{rd}-1 storage data group 710c' corresponding to the 3^{rd}-1 copy data group 510c' in the database 700, in operation S1700.

The third loader 610c may store the 3^{rd}-1 storage data group 710c' in the database 700 and then delete the 3^{rd}-1 copy data group 510c' of the buffer storage 500.

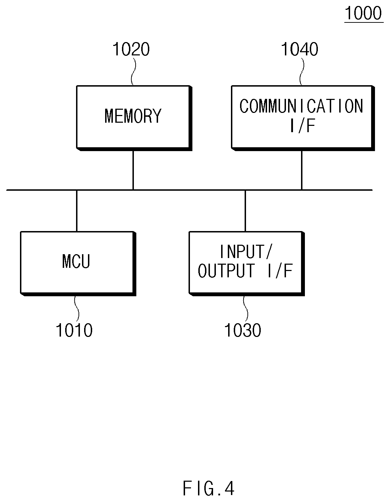

FIG. 4 is a block diagram of a hardware configuration of a computing system for performing a data processing apparatus and an operating method thereof, according to an embodiment disclosed herein.

Referring to FIG. 4, a computing system 1000 according to an embodiment disclosed herein may include a microcontroller unit (MCU) 1010, a memory 1020, an input/output interface (I/F) 1030, and a communication I/F 1040.

The MCU 1010 may execute various programs stored in the memory 1020 (e.g., a relay control program included in a battery pack, a program for collecting voltage, current, temperature, internal resistance, impedance, and the number of times of charge and discharge, etc.). The MCU 1010 may execute a program for performing processing of data that may be battery data.

According to an embodiment, the MCU 1010 may be a processor for performing a function of the battery management system 180 shown in FIG. 1 described above or a processor for performing a function of the higher-level controller 200, and a processor for performing functions of the data processing apparatus 10 shown in FIG. 2 described above. More specifically, the MCU 1010 may be a processor for performing functions of the timing controller 400, the controller (e.g., 410a), the monitoring unit 600, or the loader (e.g., 610a) of FIG. 2.

The memory 1020 may store various programs regarding collection of battery data and data processing. The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto. According to an embodiment, the memory 1020 may be included in the raw data storage 300, the buffer storage 500, or the database 700 of FIG. 2.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a data distribution device 300 may transmit and receive processed data to and from a separately provided external server through the communication I/F 1040. The data distribution device 300 may transmit and receive battery data to and from the higher-level controller 200 through the communication I/F 1040.

As such, a computer program according to an embodiment disclosed herein may be recorded in the memory 1020 and processed by the MCU 1010, thus being implemented as a module that performs functions shown in FIGS. 1 and 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A data processing apparatus comprising:
a first controller configured to select a first raw data group from a raw data storage, store a first copy data group corresponding to the first raw data group in a buffer storage, and delete the first raw data group of the raw data storage when the first copy data group is stored in the buffer storage;
a first loader configured to receive the first copy data group from the buffer storage, store a first storage data group corresponding to the first copy data group in a database, and delete the first copy data group of the buffer storage when the first storage data group is stored in the database; and
a monitoring unit configured to determine whether the first copy data group is processed, by monitoring the buffer storage.

2. The data processing apparatus of claim 1, wherein when the first loader fails to store the first storage data group corresponding to the first copy data group in the database, the monitoring unit is further configured to receive the first copy data group from the buffer storage, store the first storage data group corresponding to the first copy data group in the database and delete the first copy data group of the buffer storage when the first storage data group is stored in the database.

3. The data processing apparatus of claim 1, further comprising a second controller configured to select a second raw data group from the raw data storage, store a second copy data group corresponding to the selected second raw data group in the buffer storage, and delete the second raw data group of the raw data storage when the second copy data group is stored in the buffer storage.

4. The data processing apparatus of claim 3, further comprising a timing controller configured to execute the second controller when the first controller deletes the first raw data group of the raw data storage.

5. The data processing apparatus of claim 3, further comprising a second loader configured to receive the second copy data group from the buffer storage, store a second storage data group corresponding to the second copy data group in the database, and delete the second copy data group of the buffer storage when the second storage data group is stored in the database.

6. The data processing apparatus of claim 3, further comprising a timing controller configured to execute the second controller when the first controller fails to select the first raw data group.

7. The data processing apparatus of claim 6, wherein the second raw data group selected by the second controller comprises raw data that the first controller fails to select.

8. The data processing apparatus of claim 1, wherein the first controller is further configured to match the first copy data group with first time information and store them, the first time information being information about a generation time of the first copy data group.

9. The data processing apparatus of claim 8, wherein the monitoring unit is further configured to compare the first time information with reference time information to determine whether the first copy data group is processed.

10. An operating method of a data processing apparatus, the operating method comprising:
selecting a first raw data group from a raw data storage;
storing a first copy data group corresponding to the first raw data group in a buffer storage;
deleting the first raw data group of the raw data storage when the first copy data group is stored in the buffer storage;
storing a first storage data group corresponding to the first copy data group in a database; and
deleting the first copy data group of the buffer storage when the first copy data group is stored in the database.

11. The operating method of claim 10, further comprising determining, by a monitoring unit, whether the first copy data group is processed, by monitoring the buffer storage.

12. The operating method of claim 11, further comprising matching the first copy data group with first time information and store them, the first time information being information about a generation time of the first copy data group.

13. The operating method of claim 12, wherein the determining of whether the first copy data group is processed, comprises comparing, by the monitoring unit, the first time information with reference time information to determine whether the first copy data group is processed.

14. The operating method of claim 11, further comprising:
when a first loader fails to store the first storage data group corresponding to the first copy data group in the database,
determining, by the monitoring unit, that processing of the first copy data group is omitted;
receiving, by the monitoring unit, the first copy data group from the buffer storage;
storing, by the monitoring unit, the first storage data group corresponding to the first copy data group in the database; and
deleting the first copy data group of the buffer storage.

15. The operating method of claim 10, further comprising:
executing, by a timing controller, a second controller when a first controller deletes the first raw data group of the raw data storage;
selecting, by the second controller, a second raw data group from the raw data storage;
storing, by the second controller, a second copy data group corresponding to the selected second raw data group in the buffer storage;
deleting, by the second controller, the second raw data group of the raw data storage;
receiving, by a second loader, the second copy data group from the buffer storage;
storing, by the second loader, a second storage data group corresponding to the second copy data group in the database; and
deleting, by the second loader, the second copy data group of the buffer storage.

16. The operating method of claim 10, further comprising:
executing, by a timing controller, a second controller, when a first controller fails to select the first raw data group; and
selecting, by the second controller, a second raw data group comprising raw data the first controller fails to select, from the raw data storage.
